# FASCICULE DE BREVET EUROPEEN

(11) **EP 1 163 718 B1**
(45) Date de publication et mention de la délivrance du brevet: **04.09.2002**
(21) Numéro de dépôt: 00911025.5
(22) Date de dépôt: 22.03.2000
(51) Int. Cl.: H03C 1/36

(54) **PROCEDE DE MODULATION DE L'AMPLITUDE D'UN SIGNAL D'ANTENNE**
VERFAHREN ZUM MODULIEREN DER AMPLITUDE EINES SIGNALS UND DESSEN AUSSTRAHLUNG DURCH EINE ANTENNE
METHOD FOR MODULATING THE AMPLITUDE OF AN ANTENNA SIGNAL

(30) Priorité: 25.03.1999 FR 9904108
(43) Date de publication de la demande: 19.12.2001
(73) Titulaire: Inside technologies, 69930 Saint-Clément-les-Places (FR)
(72) Inventeur: CHARRAT, Bruno, F-13090 Aix en Provence (FR)
(74) Mandataire: Marchand, André
(86) Numéro de dépôt international: FR0000712
(87) Numéro de publication internationale: WO00059108

(56) Documents cités:
- EP-A- 0 693 843
- DE-A- 19 627 640
- US-A- 3 003 122
- US-A- 4 490 854
- US-A- 4 529 950

## Description

La présente invention concerne un dispositif de transmission de données par couplage inductif, comprenant un circuit d'antenne inductif excité par un signal d'antenne et un circuit de commande comportant des ports binaires pouvant être portés à haute impédance et présentant une résistance interne non nulle.

La présente invention concerne notamment les dispositifs prévus pour échanger des données avec des objets portatifs électroniques comportant un circuit intégré sans contact, comme les lecteurs de cartes à puce sans contact, les lecteurs d'étiquettes électroniques, les lecteurs de badges électroniques,...

Selon les projets de normes ISO 14443-2/A ou 14443-2/B, désignées par la suite "ISO/A" et "ISO/B", la bobine d'antenne d'un lecteur de circuit intégré sans contact est excitée par un signal d'antenne oscillant à la fréquence de 13,56 MHz. La transmission de données au circuit intégré est effectuée par modulation de l'amplitude du signal d'antenne, avec une profondeur de modulation de 100% dans le cas de norme ISO/A ou de 10% dans le cas de la norme ISO/B.

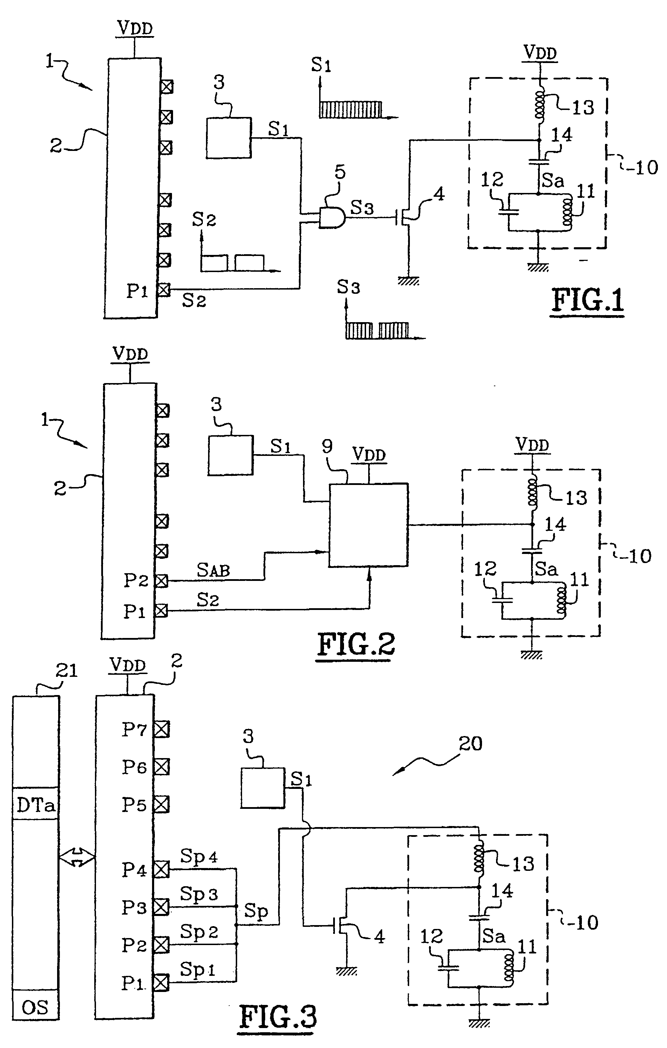

La figure 1 représente un dispositif 1 de transmission de données classique comprenant un microprocesseur 2, un oscillateur 3, un transistor de modulation 4 et un circuit d'antenne 10 de type résonant. Le circuit d'antenne 10 comprend une bobine d'antenne 11 en parallèle avec une capacité 12 et reçoit une tension d'alimentation continue VDD par l'intermédiaire d'une inductance 13 et d'une capacité d'isolement 14. Le transistor de modulation 4 est connecté aux bornes de la bobine 11 par l'intermédiaire de la capacité d'isolement 14. L'oscillateur 3 délivre un signal S1 oscillant à 13,56 MHz et le microprocesseur 2 délivre sur un port P1 un signal binaire S2 de modulation d'amplitude. Les signaux S1 et S2 sont appliqués à une porte ET 5 dont la sortie délivre un signal de modulation S3 appliqué sur la grille du transistor 4, dont l'aspect est représenté sur la figure 1. Le signal d'antenne Sa traversant la bobine 11 est l'image du signal S3.

Ce dispositif de transmission de données offre l'avantage d'être d'une structure relativement simple mais permet seulement de moduler à 100% l'amplitude du signal d'antenne (ISO/A). Pour l'obtention d'une modulation à 10% du signal d'antenne Sa (ISO/B), le dispositif devient plus complexe et divers éléments doivent être ajoutés.

Le dispositif devient encore plus complexe si l'on veut qu'il soit compatible avec les normes ISO/A et ISO/B afin de pouvoir transmettre des données à deux types différents de circuits intégrés. Dans ce cas, comme cela est illustré par la figure 2, l'interrupteur de modulation 4 est remplacé par un circuit de modulation 9 représenté sous la forme d'un bloc. Le circuit de modulation 9 reçoit les signaux S1, S2 ainsi qu'un signal S_{AB} délivré par un port P2 du microprocesseur, permettant de sélectionner le type de modulation souhaité. Un tel circuit de modulation 9 nécessite pour sa réalisation divers composants électriques et/ou électroniques.

Ainsi, un objectif de la présente invention est de prévoir un dispositif de transmission de données du type décrit ci-dessus qui puisse moduler le signal d'antenne avec une profondeur de modulation inférieure à 100% tout en étant d'une structure simple et peu coûteuse à réaliser.

Un objectif plus particulier de la présente invention est de prévoir un dispositif de transmission de données qui soit polyvalent et puisse moduler le signal d'antenne avec plusieurs profondeurs de modulation, notamment des profondeurs de modulation de 10% et de 100%.

La présente invention concerne également la réception de données envoyées par un circuit intégré sans contact par la méthode de modulation de charge. Dans ce cas, la bobine 11 du dispositif de transmission de données décrit plus haut reçoit par couplage inductif un signal de modulation de charge qui se trouve mélangé au signal d'antenne Sa. Le signal de modulation de charge doit être extrait du signal d'antenne Sa et démodulé par un filtrage approprié avant d'être décodé. Les systèmes de démodulation et de filtrage connus présentent l'inconvénient d'être complexes si l'on souhaite qu'ils soient compatibles avec plusieurs protocoles de modulation de charge, notamment ceux prévus par les normes ISO/A et ISO/B.

Ainsi, encore un autre objectif de la présente invention est de prévoir un dispositif de démodulation qui soit compatible avec plusieurs protocoles de modulation de charge, tout en étant d'une structure simple et peu coûteuse à réaliser.

Pour atteindre ces objectifs, la présente invention prévoit un procédé pour moduler l'amplitude du signal d'antenne d'un circuit d'antenne inductif comportant une bobine, au moyen d'un circuit de commande comportant des ports binaires pouvant être portés à l'état haute impédance et présentant une résistance interne non nulle, procédé dans lequel le circuit d'antenne est alimenté électriquement par au moins deux ports du circuit de commande, et comprenant les étapes consistant à : mettre à "1" les ports assurant l'alimentation électrique du circuit d'antenne, pour l'alimentation du circuit d'antenne à pleine puissance, et modifier l'état d'au moins l'un des ports assurant l'alimentation électrique du circuit d'antenne, pour moduler l'amplitude du signal d'antenne.

Selon un mode de réalisation, les ports assurant l'alimentation électrique du circuit d'antenne sont mis à "0" pour une modulation à 100% du signal d'antenne.

Selon un mode de réalisation, au moins un port est porté à l'état haute impédance pendant que le ou les autres ports sont maintenus à "1" pour une modulation de l'amplitude du signal d'antenne inférieure à 100%.

Selon un mode de réalisation, le signal d'antenne est en outre modulé en fréquence par des moyens interrupteurs connectés aux bornes de la bobine et pilotés par un signal alternatif.

La présente invention concerne également un dispositif d'émission de données par couplage inductif, comprenant un circuit d'antenne de type inductif comportant une bobine traversée par un signal d'antenne, un circuit de commande du circuit d'antenne comportant des ports binaires pouvant être portés à haute impédance et présentant une résistance interne non nulle, dans lequel le circuit d'antenne est alimenté électriquement par au moins deux ports du circuit de commande, et le circuit de commande est agencé pour moduler l'amplitude du signal d'antenne conformément au procédé de l'invention.

Selon un mode de réalisation, la dispositif comprend un oscillateur délivrant un signal alternatif, et des moyens interrupteurs pilotés par le signal alternatif agencés aux bornes de la bobine d'antenne pour moduler la fréquence du signal d'antenne.

La présente invention concerne également un dispositif d'émission et de réception de données du type ci-dessus, comprenant un filtre passe-bande et un filtre passe-bas agencés pour recevoir sur une première borne un signal de modulation de charge présent dans le signal d'antenne, et connectés chacun par leur autre borne à un port du circuit de commande.

Ces caractéristiques de la présente invention, ainsi que d'autres, seront exposées plus en détail dans la description suivante d'un procédé et d'un dispositif de transmission de données selon l'invention, et d'un dispositif de réception de données selon l'invention, en relation avec les figures jointes parmi lesquelles :
- les figures 1 et 2 précédemment décrites sont des schémas électriques de dispositifs classiques de transmission de données par induction,
- la figure 3 est le schéma électrique d'un dispositif de transmission de données selon l'invention,
- la figure 4 est le schéma électrique d'un port de microprocesseur,
- la figure 5 est le schéma logique d'un port de microprocesseur,
- les figures 6A à 6G représentent divers signaux apparaissant dans le dispositif de la figure 3, selon un premier aspect du procédé de l'invention,
- les figures 7A à 7G représentent divers signaux apparaissant dans le dispositif de la figure 3, selon un deuxième aspect du procédé de l'invention, et
- la figure 8 est le schéma électrique d'un dispositif d'émission/réception de données selon l'invention.

### Premier aspect de l'invention : modulation d'un signal d'antenne

La figure 3 représente schématiquement un dispositif 20 de transmission de données selon l'invention, dont la structure est très proche de celle du dispositif de la figure 2. On retrouve dans le dispositif 20 le circuit d'antenne 10, le microprocesseur 2 alimenté par la tension VDD, l'oscillateur 3 délivrant un signal S1 à 13,56 MHz, ainsi que l'interrupteur de modulation 4 connecté aux bornes de la bobine 11 par l'intermédiaire de la capacité d'isolement 14. Le microprocesseur 2 comporte des ports binaires P1 à P7 qui peuvent être portés à "1" (tension VDD), à "0" (sortie du port à la masse) ou à l'état haute impédance. Enfin, le microprocesseur 2 est équipé d'une mémoire 21 dans laquelle se trouve notamment des données DTa devant être émises par modulation de l'amplitude du signal d'antenne Sa, et le système d'exploitation OS du microprocesseur.

Selon l'invention, l'alimentation électrique du circuit d'antenne 10 est assurée par plusieurs ports du microprocesseur connectés en parallèle, ici les ports P1, P2, P3, P4. Les ports P1 à P4 délivrent un signal d'alimentation Sp qui est la combinaison de signaux Sp1, Sp2, Sp5, Sp4 délivrés par chacun des ports, et qui est appliqué au circuit d'antenne 10 par l'intermédiaire de l'inductance 13 et de la capacité 14 déjà décrites. L'inductance 13, ou inductance "de choc", protège les ports P1 à P4 contre les surtensions et la capacité 14 isole la bobine 11 du courant continu. Ici, l'interrupteur de modulation 4 est piloté par le signal S1 et ne reçoit pas de signal de modulation d'amplitude délivré par le microprocesseur, comme cela est le cas dans l'art antérieur.

Selon le procédé de l'invention, les quatre ports P1 à P4 sont maintenu à l'état "1" (tension VDD présente sur les ports) pour l'alimentation à pleine puissance du circuit d'antenne 10. L'amplitude du signal d'antenne Sa est modulée en modulant l'amplitude du signal d'alimentation Sp lui-même, et l'amplitude du signal d'alimentation Sp est modulée en modifiant l'état de tout ou partie des ports P1 à P4.

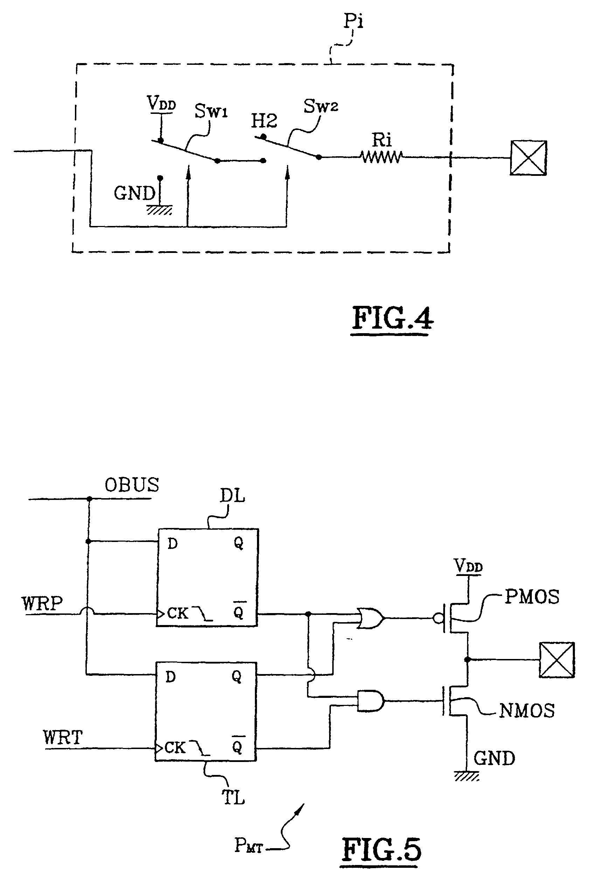

Avant de décrire plus en détail cet aspect de l'invention, on rappelle en relation avec la figure 4 qu'un port Pi de microprocesseur comprend généralement une résistance interne Ri non nulle et peut être schématisé par une ligne électrique comprenant deux interrupteurs Sw1 Sw2 et la résistance Ri en série. L'interrupteur Sw1 permet de porter la sortie du port Pi à la tension d'alimentation V_{DD} ("1" logique) ou à la masse ("0" logique). L'interrupteur Sw2 permet de déconnecter l'interrupteur Sw1 pour placer la sortie du port Pi à l'état haute impédance HZ. La résistance Ri représente la résistance interne du port Pi, et provoque une chute de tension qui est fonction du courant délivré par le port.

A titre d'exemple concret, la figure 5 représente le schéma logique d'un port P_{MT} du microprocesseur PIC16C6X commercialisé par la société Microchip Technology™ Inc., utilisé par la demanderesse pour évaluer la présente invention. Le port P_{MT} comprend deux bascules à verrouillage DL et TL pilotées par l'intermédiaire du bus de donnees DBUS du microprocesseur, et par des signaux WRP d'écriture du port et WRT de mise à haute impédance du port. La sortie du port est prélevée au point milieu de deux transistors de sortie PMOS et NMOS en série, alimentés par la tension V_{DD} et commandés par les sorties Q ou /Q des bascules DL, TL. La résistance interne Ri du port est ici la résistance du transistor PMOS lorsque celui-ci est passant (sortie du port à 1).

Ainsi, si l'on se réfère à la figure 3, la modulation du signal d'antenne Sa est obtenue en mettant à 0 tous les ports P1 à P4 ou en portant certains ports à haute impédance pendant que les autres ports sont maintenus à 1. Dans le premier cas, le signal d'alimentation Sp est nul et l'amplitude du signal d'antenne Sa est modulée à 100% (norme ISO/A). Dans le second cas, les ports maintenus à 1 sont traversés par un courant plus important et leur résistance interne Ri fait chuter la tension du signal d'alimentation Sp sans l'annuler, de sorte que le signal d'antenne Sa présente une modulation d'amplitude inférieure à 100%.

En pratique, le nombre de ports devant être portés à haute impédance dépend de la profondeur de modulation recherchée et des propriétés électriques des ports utilisés. Avec le microprocesseur PIC16C6X alimenté par une tension V_{DD} de 5V, et un circuit d'antenne 10 présentant une impédance caractéristique de l'ordre de 250Ω à 13,56 MHz, des essais conduits par la demanderesse ont montré que trois ports sur quatre doivent être portés à haute impédance pour obtenir une modulation d'amplitude du signal d'antenne Sa de l'ordre de 10%, conforme à la norme ISO/B. Plus particulièrement, lorsque les ports P1 à P4 sont à "1" le courant traversant chaque port est de l'ordre de 5 mA, ce qui représente un courant d'antenne de l'ordre de 20 mA. La tension appliquée au circuit d'antenne est de l'ordre de 4,775 V. Lorsque trois ports sur quatre sont portés à haute impédance, par exemple les ports P2 à P4, le port P1 étant mainrenu à 1, le courant traversant le port P1 est de l'ordre de 15 mA et que la tension appliquée au circuit d'antenne est de l'ordre de 4,3 V, soit une modulation de l'amplitude du signal d'antenne Sa de l'ordre de 10%.

Ainsi, le dispositif 20 de la figure 3 présente l'avantage de pouvoir répondre aux normes ISO/A et ISO/B selon la manière dont les ports P1 à P4 sont commandés, tout en bénéficiant d'une structure particulièrement simple.

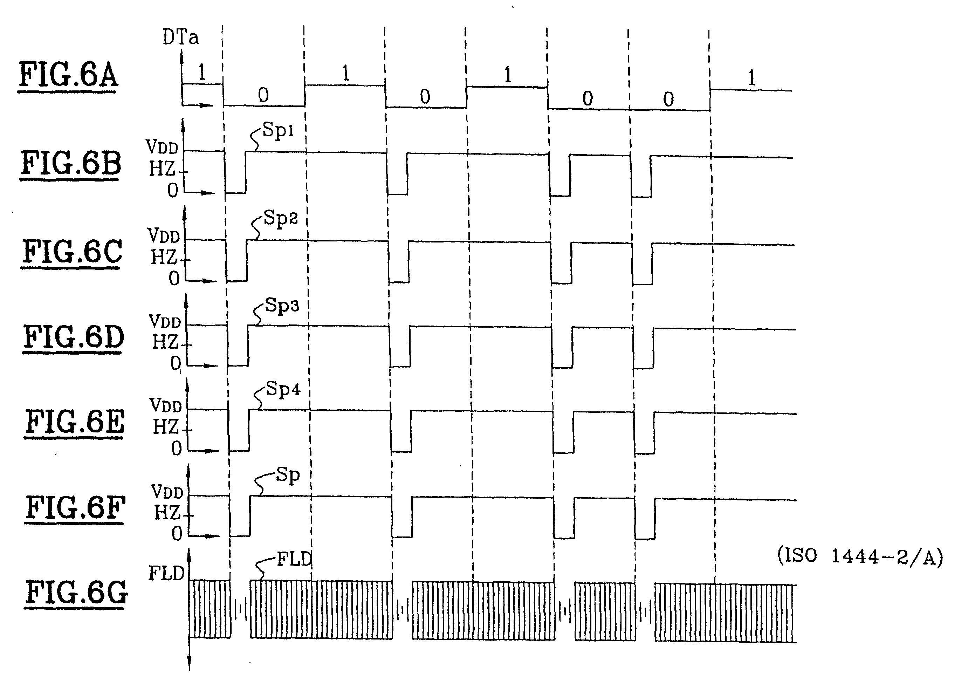

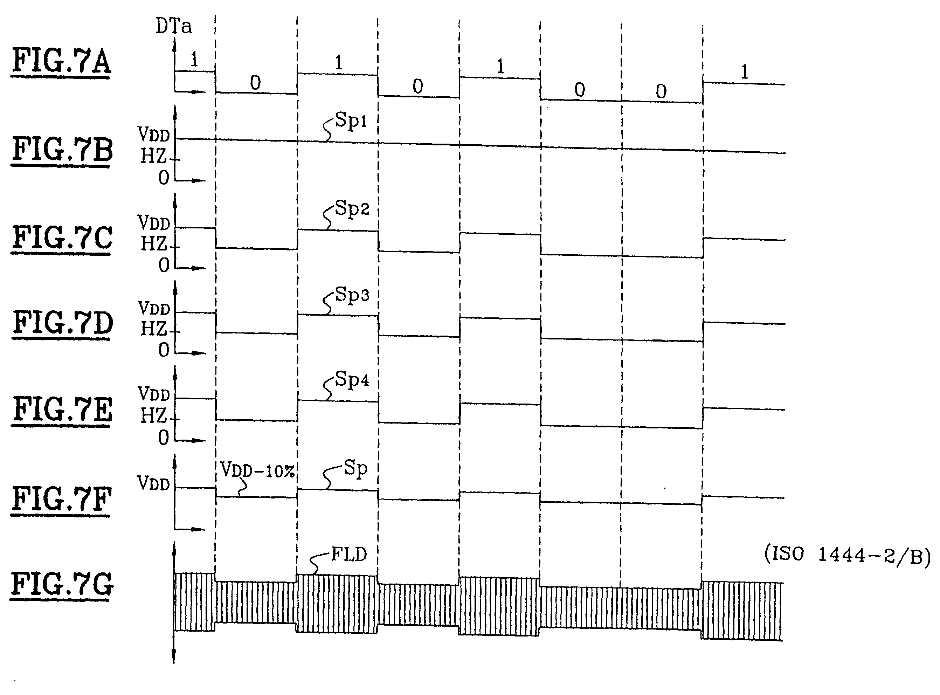

Pour fixer les idées, les chronogrammes des figures 6A à 6G illustrent le protocole de commande des ports P1 à P4 pour une transmission de données selon la norme ISO/A, et les chronogrammes des figures 7A à 7G illustrent le protocole de commande des ports P1 à P4 pour une transmission de données selon la norme ISO/B. Les figures 6A, 7A représentent le signal logique DTa à transmettre, constitué par une suite de bits dont les valeurs ne sont données qu'à titre d'exemple. Les figures 6B à 6E, 7B à 7E représentent les signaux Sp1 à Sp4. Les figures 6F, 7F représentent le signal Sp. Enfin, l'aspect du champ magnétique FLD émis par la bobine d'antenne 5 est illustré par les figures 6G, 7G. Sur les chronogrammes des figures 6B à 6F, 7B à 7F, l'état haute impédance est représenté par un niveau logique fictif HZ.

Sur les figures 6A à 6G, on voit que le champ magnétique FLD est émis à pleine puissance pendant la transmission d'un bit à 1, le signal Sp étant de l'ordre de 5V. Un bit à 0 est codé par une impulsion à 0 du signal Sp, de courte durée, obtenue par la mise à 0 simultanée des ports P1 à P4 (signaux Sp1 à Sp4 à 0). Une impulsion à 0 du signal Sp provoque une interruption de courte durée du champ magnétique FLD émis par la bobine d'antenne 5 (modulation à 100%).

Sur les figures 7A à 7G, le champ magnétique FLD est également émis à pleine puissance pendant la transmission d'un bit à 1. Par contre, un bit à 0 est codé par une modulation à 10% de l'amplitude du signal Sp pendant toute la durée T du bit (codage NRZ), T étant la période binaire du signal DTa. La modulation à 10% est assurée par le maintien à 1 du port P1 et la mise à haute impédance des ports P2, P3, P4 (signaux Sp2, Sp3, Sp4 dans l'état HZ). La modulation à 10% du signal Sp provoque une modulation de 10% du champ magnétique FLD, puisque le signal Sp est le signal d'alimentation du circuit d'antenne 10.

Bien entendu, les valeurs numériques et combinaisons de commandes décrites plus haut ne constituent que des exemples. Il appartient à l'homme de l'art de mettre en oeuvre l'invention avec un plus ou moins grand nombre de ports, selon les caractéristiques du microprocesseur utilisé, le taux de modulation recherché et l'impédance du circuit d'antenne. A la limite, un seul port peut s'avérer suffisant pour réaliser un dispositif ne répondant qu'à la norme ISO/A, à la condition que le port puisse délivrer un courant suffisant pour atteindre la puissance maximale d'émission du champ magnétique, qui est définie par l'application envisagée et la distance de communication souhaitée.

D'autre part, bien que l'on ait décrit plus haut un exemple de réalisation de l'invention au moyen d'un microprocesseur du commerce, tout type de circuit de commande offrant les caractéristiques susmentionnées peut permettre de réaliser l'invention. Notamment, l'invention peut être mise en oeuvre au moyen d'un circuit intégré spécifique de type "ASIC" ("Assigned Specific Integrated Circuit"). Un tel circuit intégré spécifique peut intégrer un microprocesseur ou un circuit logique programmable comportant lignes de commutation de type "port" d'une structure équivalente à celle d'un port de microprocesseur. Dans ce cas, les ports du microprocesseur dédiés à la modulation du signal d'antenne, ou les lignes de commutation de type "port", peuvent être connectés à l'intérieur même du circuit intégré spécifique, de manière que le circuit spécifique ne présente qu'un plot de sortie pour la commande du circuit d'antenne.

### Deuxième aspect de l'invention : réalisation d'un circuit de réception d'un signal transmis par couplage inductif

Selon un autre aspect de l'invention, les ports d'un microprocesseur sont également utilisés pour réaliser de façon simple un système de filtrage actif permettant de recevoir des données émises par des circuits intégrés utilisant plusieurs protocoles de communication, notamment les protocoles ISO/A et ISO/B.

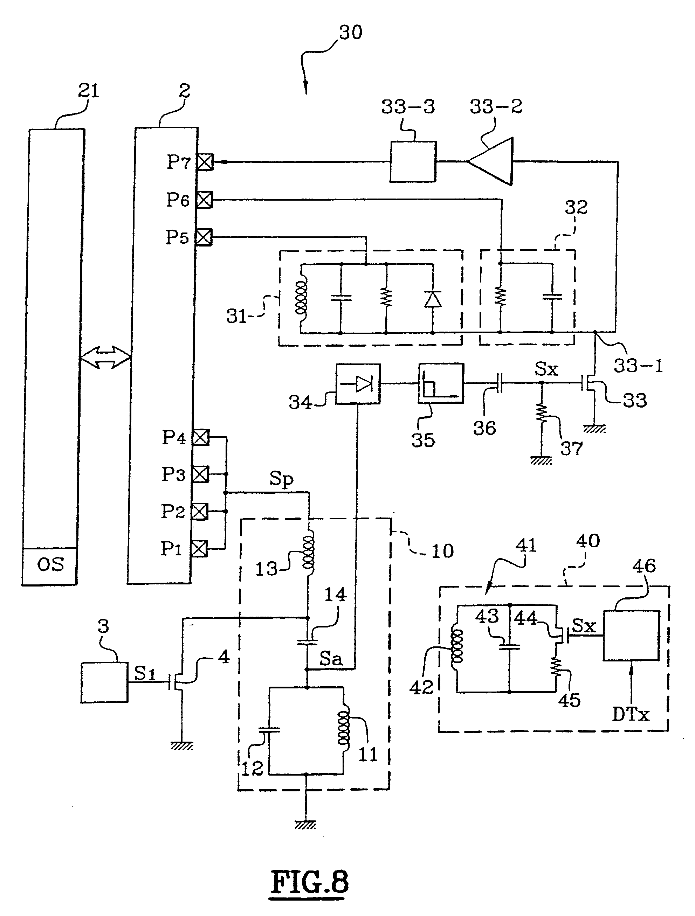

La figure 8 représente un dispositif 30 d'émission/réception de données par couplage inductif mettant en oeuvre cet aspect de l'invention. Le dispositif 30 comprend les mêmes éléments que le dispositif 20 de la figure 3, désignés par les mêmes références, ainsi que des moyens de réception de données qui seront décrits plus loin. Ces moyens de réception ont pour fonction d'extraire du signal d'antenne Sa un signal de modulation de charge envoyé par un circuit intégré 40 fonctionnant sans contact.

Un tel circuit intégré 40, représenté schématiquement sur la figure 8, comprend un circuit d'antenne 41 et un système de modulation de charge. Le circuit d'antenne 41 comprend une bobine d'antenne 42 et une capacité 43 en parallèle. Le système de modulation de charge comprend par exemple un interrupteur 44 et une résistance 45 en série connectés aux bornes de la bobine 42. L'interrupteur 44 est piloté par un signal de modulation Sx délivré par un circuit codeur 46, qui reçoit en entrée des données DTx à transmettre. Lorsque les bobines 11 et 42 sont suffisamment proches, le signal Sx se répercute par couplage inductif dans la bobine 11 pour former une composante du signal d'antenne Sa. Le signal Sx comporte de façon classique une composante alternative ou sous-porteuse d'une fréquence de 847 KHz et doit être extrait du signal Sa et démodulé avant d'être décodé par le microprocesseur 2 ou par tout autre moyen de décodage approprié.

Selon l'invention, les moyens de réception comprennent un filtre passe-bande 31 calé sur une fréquence de 847 KHz et un filtre passe-bas 32 ayant une fréquence de coupure de 847 KHz. Le filtre passe-bande 31 comprend ici une inductance, une capacité, une résistance et une diode en parallèle, et le filtre passe-bas 32 comprend une résistance et une capacité en parallèle. Chaque filtre 31, 32 est connecté par l'une de ses extrémités à un port du microprocesseur 2, respectivement P5 et P6. L'autre extrémité des filtres 31, 32 est connectée à un noeud commun 33-1. Le noeud 33-1 est connecté à la sortie d'un élément amplificateur 33 prenant ici la forme d'un transistor FET ayant son drain connecté au noeud 33-1 et sa source connectée à la masse. Le noeud 33-1 est également connecté à un port P7 du microprocesseur par l'intermédiaire d'un amplificateur 33-2 et d'un dispositif 33-3 de mise en forme du signal du type "déclencheur" ("trigger") ou type amplificateur différentiel. La bobine d'antenne 11, traversée par le signal d'antenne Sa, est connectée à un redresseur monoalternance 34 dont la sortie est appliquée à un filtre passe-bas 35 ayant une fréquence de coupure de l'ordre du MégaHertz de manière à supprimer -toute composante à 13,56 MHz. La sortie du filtre 35 est appliquée à l'entrée de l'élément amplificateur 33 (ici la grille du transistor FET) par l'intermédiaire d'une capacité 36 et d'une résistance 37 de stabilisation du niveau bas ("pull-down").

Ainsi, l'élément amplificateur 33 reçoit en entrée le signai de modulation de charge Sx, qui est extrait du signal d'antenne Sa par le filtre passe-bas 35. Lorsque les ports P5, P6 sont à haute impédance, les filtres 31, 32 sont déconnectés (en circuit ouvert) et le noeud 33-1 est à haute impédance. Lorsqu'un port P5, P6 est mis à 1 pendant que l'autre port est maintenu à haute impédance, le filtre 31, 32 correspondant est mis en service et permet d'extraire l'enveloppe du signal Sx, en éliminant la sous-porteuse. L'enveloppe du signal Sx est envoyée sur le port P7 du microprocesseur pour être décodée, après avoir été amplifiée par l'amplificateur 33-2 et mise en forme par le déclencheur 33-3.

Le dispositif 30 selon l'invention présente l'avantage d'être simple tout en permettant de recevoir des données envoyées selon divers protocoles de transmission, les ports P6 et P7 ayant pour fonction de commuter les filtres 31, 32 tout en assurant leur alimentation électrique. Par exemple, le microprocesseur 2 sélectionne et active le filtre passe-bas 32 en mettant le port P6 à "1" lorsque le signal Sx est une sous-porteuse d'une fréquence de 847 KHz codée Manchester (norme ISO/A). Le microprocesseur 2 sélectionne et active le filtre passe-bande 31 quand le signal Sx est une sous-porteuse de 847 KHz codée BPSK ("Binary Phase Shift Keying"), c'est-à-dire par sauts de phase (norme ISO/B).

De façon générale, le filtre passe-bas 32 permet de démoduler en fréquence tout type de signal Sx dont la fréquence est inférieure ou égale à 847 KHz, y compris lorsque le signal Sx est un signal binaire sans sous-porteuse. Le filtre passe-bande 31 est plus particulièrement dédié à la démodulation de phase du signal Sx lorsque celui-ci est codé BPSK est présente une fréquence de 847 KHz.

Bien entendu, divers autres filtres peuvent être prévus et connectés à d'autres ports du microprocesseur. Par ailleurs, les fréquences de 13,56 MHz et de 847 KHz n'ont été données qu'en tant qu'exemples décrits par le projet de norme ISO 14443-2.

De façon générale, les deux aspects de l'invention sont indépendants l'un de l'autre. Toutefois, leur juxtaposition permet de réaliser des lecteurs de circuits intégrés sans contact polyvalents et d'un faible prix de revient, l'objectif ultime de la présente invention étant de favoriser et de promouvoir l'emploi des circuits intégrés sans contact dans les applications "grand public" comme porte-monnaie électronique, la carte téléphonique, le ticket de transport électronique, l'identification d'objets (étiquettes électroniques), le contrôle d'accès (badges électroniques),...

## Revendications

1. Procédé pour moduler l'amplitude du signal d'antenne (Sa) d'un circuit d'antenne inductif (10) comportant une bobine (11), au moyen d'un circuit (2) de commande comportant des ports binaires (P1-P7) pouvant être portés à l'état haute impédance (HZ) et présentant une résistance interne non nulle, **caractérisé en ce que** le circuit d'antenne (10) est alimenté électriquement par au moins deux ports (P1-P4) du circuit de commande (2), et **en ce qu'**il comprend les étapes consistant à :
- mettre a "1" les ports (P1-P4) assurant l'alimentation électrique du circuit d'antenne (10), pour l'alimentation du circuit d'antenne à pleine puissance, et
- modifier l'etat d'au moins l'un des ports (P1-P4) assurant l'alimentation électrique du circuit d'antenne (10), pour moduler l'amplitude du signal d'antenne (Sa).

2. Procedé selon la revendication 1, dans lequel les ports (P1-P4) assurant l'alimentation électrique du circuit d'antenne (10) sont mis à "0" pour une modulation à 100% du signal d'antenne.

3. Procedé selon la revendication 1, dans lequel au moins un port (P2-P4) est porté à l'état haute impédance (HZ) pendant que le ou les autres ports (P1) sont maintenus à "1" pour une modulation de l'amplitude du signal d'antenne inférieure à 100%.

4. Procédé selon l'une des revendications 1 à 3, dans lequel le signal d'antenne (Sa) est en outre modulé en fréquence par des moyens interrupteurs (4) connectés aux bornes de la bobine (11) et pilotés par un signal alternatif (S1).

5. Dispositif (20, 30) d'émission de données par couplage inductif, comprenant un circuit d'antenne de type inductif (10) comportant une bobine (11) traversée par un signal d'antenne (Sa), un circuit de commande (2) du circuit d'antenne (10) comportant des ports binaires (P1-P7) pouvant être portés à haute impédance (HZ) et présentant une résistance interne non nulle, **caractérisé en ce que** le circuit d'antenne (10) est alimenté électriquement par au moins deux ports (P1-P4) du circuit de commande (2), et en ce-que le circuit de commande (2) est agencé pour moduler l'amplitude du signal d'antenne (Sa) conformément au procédé de l'une des revendications 1 à 3.

6. Dispositif selon la revendication 5, comprenant un oscillateur (3) délivrant un signal alternatif (S1), et des moyens interrupteurs pilotés par le signal alternatif (S1) agencés aux bornes de la bobine d'antenne (11) pour moduler la fréquence du signal d'antenne (Sa).

7. Dispositif d'émission et de réception de données selon l'une des revendications 5 et 6, comprenant un filtre passe-bande (31) et un filtre passe-bas (32) agencés pour recevoir sur une première borne un signal de modulation de charge (Sx) présent dans le signal d'antenne (Sa), et connectés chacun par leur autre borne à un port (P5, P6) du circuit de commande (2).

8. Dispositif selon la revendication 7, dans lequel le circuit de commande (2) est agencé pour sélectionner l'un des filtres (31, 32) en portant à "1" le port connecté au filtre à sélectionner, et en portant à l'état haute impédance le port connecté à l'autre filtre.

## Claims

1. A method of modulating the amplitude of the antenna signal (Sa) of an inductive antenna circuit (10) comprising a coil (11), by means of a control circuit (2) comprising binary ports (P1-P7) which can be set to the high impedance state (HZ) and having a non-zero internal resistance, **characterised in that** the antenna circuit (10) is supplied electrically by at least two ports (P1-P4) of the control circuit (2), and that it comprises the following steps:
- setting to '1' the ports (P1-P4) providing the electrical supply to the antenna circuit (10), for supplying the antenna circuit at full power, and
- modifying the state of at least one of the ports (P1-P4) providing the electrical supply to the antenna circuit (10) for modulating the amplitude of the antenna signal (Sa).

2. A method according to claim 1 wherein the ports (P1-P4) providing the electrical supply to the antenna circuit (10) are set to '0' for 100% modulation of the antenna signal.

3. A method according to claim 1 wherein at least one port (P2-P4) is brought to the high impedance state (HZ) while the other port or ports (P1) are maintained at '1' for modulation of the amplitude of the antenna signal of less than 100%.

4. A method according to one of claims 1 to 3 wherein the antenna signal (Sa) is further modulated in respect of frequency by switch means (4) which are connected to the terminals of the coil (11) and which are pilot-controlled by an alternating signal (S1).

5. An apparatus (20, 30) for emitting data by inductive coupling, comprising an antenna circuit (10) of inductive type comprising a coil (11) through which an antenna signal (Sa) passes, a control circuit (2) for controlling the antenna circuit (10) and comprising binary ports (P1-P7) which can be set to high impedance (HZ) and having a non-zero internal resistance, **characterised in that** the antenna circuit (10) is supplied electrically by at least two ports (P1-P4) of the control circuit (2), and that the control circuit (2) is arranged to modulate the amplitude of the antenna signal (Sa) in accordance with the method of one of claims 1 to 3.

6. Apparatus according to claim 5 comprising an oscillator (3) delivering an alternating signal (S1) and switch means which are pilot-controlled by the alternating signal (S1) and arranged at the terminals of the antenna coil (11) for modulating the frequency of the antenna signal (Sa).

7. An apparatus for emitting and receiving data according to one of claims 5 and 6 comprising a band pass filter (31) and a low pass filter (32) which are arranged to receive at a first terminal a load modulation signal (Sx) present in the antenna signal (Sa) and each connected by their other terminal to a port (P5, P6) of the control circuit (2).

8. Apparatus according to claim 7 wherein the control circuit (2) is arranged to select one of the filters (31, 32), by setting to '1' the port connected to the filter to be selected and by setting to the high impedance state the port connected to the other filter.

## Patentansprüche

1. Verfahren zum Modulieren der Amplitude des Antennen-Signals (Sa) eines induktiven Antennen-Schaltkreises (10), enthaltend eine Spule (11), mindestens einen Befehl-Schaltkreis (2), enthaltend binäre Pforten (P1 bis P7), die auf einem Zustand eines hohen Scheinwiderstands (HZ) gehalten werden können und einen Innen-Widerstand von nicht Null aufweisen, **dadurch gekennzeichnet, dass** der Antennen-Schaltkreis (10) elektrisch von mindestens zwei Pforten (P1 bis P4) des Befehl-Schaltkreises (2) versorgt wird, wobei das Verfahren die Stufen aufweist, in denen man:
- die Pforten (P1 bis P4) auf "1" setzt, wobei die elektrische Versorgung des Antennen-Schaltkreises (10) zur Versorgung des Antennen-Schaltkreises mit voller Energie gewährleistet wird, und man
- den Zustand von mindestens einer der Pforten (P1 bis P4) modifiziert, wobei die elektrische Versorgung des Antennen-Schaltkreises (10) gewährleistet wird, um die Amplitude des Antennen-Signals (Sa) zu modulieren.

2. Verfahren gemäß Anspruch 1, wobei die Pforten (P1 bis P4), die die elektrische Versorgung des Antennen-Schaltkreises (10) gewährleisten, auf "0" für eine Modulation auf 100% des Antennen-Signals gesetzt werden.

3. Verfahren gemäß Anspruch 1, wobei mindestens eine Pforte (P2 bis P4) im Zustand eines hohen Scheinwiderstands (HZ) gehalten wird, während dessen die oder die weiteren Pforte(n) (P1) für eine Modulation der Amplitude des Antennen-Signals unterhalb 100% bei "1" gehalten werden.

4. Verfahren gemäß einem der Ansprüche 1 bis 3, wobei das Antennen-Signal (Sa) außerdem durch Unterbrecher-Mittel (4) Frequenz-moduliert wird, die mit Anschlüssen der Spule (11) verbunden sind und von einem Alternativ-Signal (S1) pilotiert werden.

5. Vorrichtung (20, 30) zur Ausgabe von Daten durch induktive Kupplung, umfassend einen Antennen-Schaltkreis (10) vom induktiven Typ, enthaltend eine Spule (11), die von einem Antennen-Signal (Sa) überquert wird, einen Befehl-Schaltkreis (2) des Antennen-Schaltkreises (10), enthaltend binäre Pforten (P1 bis P7), die bei hohem Scheinwiderstand (HZ) gehalten werden können und einen Innen-Widerstand von nicht Null aufweisen, **dadurch gekennzeichnet, dass** der Antennen-Schaltkreis (10) elektrisch von mindestens zwei Pforten (P1 bis P4) des Befehl-Schaltkreises (2) versorgt wird, und dass der Befehl-Schaltkreis (2) angeordnet ist, um die Amplitude des Antennen-Signals (Sa) mit dem Verfahren gemäß einem der Ansprüche 1 bis 3 zu modulieren.

6. Vorrichtung gemäß Anspruch 5, enthaltend einen Oszillator (3), der ein Alternativ-Signal (S1) aussendet, und Unterbrecher-Mittel, die von dem Alternativ-Signal (S1) pilotiert werden und an den Anschlüssen der Antennen-Spule (11) angeordnet sind, um die Frequenz des Antennen-Signals (Sa) zu modulieren.

7. Vorrichtung gemäß einem der Ansprüche 5 und 6 zur Ausgabe und Aufnahme von Daten, umfassend einen Pass-Band-Filter (31) und eien Pass-Band-Filter (32), die zum Empfang auf einem ersten Anschluss eines Ladungsmodulationssignals (Sx), das im Antennen-Signal (Sa) vorliegt, angeordnet sind und jeder durch seinen anderen Anschluss mit einer Pforte (P5, P6) des Befehl-Schaltkreises (2) verbunden ist.

8. Vorrichtung gemäß Anspruch 7, worin der Befehl-Schaltkreis (2) angeordnet ist, um einen der Filter (31, 32) auszuwählen, wobei die Pforte, die an den Auswahl-Filter angeschlossen ist, bei "1" und im Zustand eines hohen Scheinwiderstands gehalten werden.
